# FASCICULE DE BREVET EUROPEEN

(11) **EP 2 764 617 B1**
(45) Date de publication et mention de la délivrance du brevet: **22.05.2019**
(21) Numéro de dépôt: 12769100.4
(22) Date de dépôt: 05.10.2012
(51) Int. Cl.: H03H 9/17, H03H 3/04, H03H 9/13, H03H 9/02

(54) **RÉSONATEURS À ONDES DE VOLUME SUR STRUCTURES VERTICALES MICRO-USINÉES**
VOLUMENWELLENRESONATOREN AUF MIKROGEFERTIGTEN VERTIKALEN STRUKTUREN
VOLUME WAVE RESONATORS ON MICROMACHINED VERTICAL STRUCTURES

(30) Priorité: 05.10.2011 FR 1158964
(43) Date de publication de la demande: 13.08.2014
(73) Titulaire: Centre National de la Recherche Scientifique (C.N.R.S.), 75016 Paris (FR); Université de Franche-Comté, 25030 Besançon Cedex (FR); Centre National d'Etudes Spatiales, 75001 Paris (FR); ECOLE NATIONALE SUPERIEURE DE MECANIQUE ET DES MICROTECHNIQUES, 25030 Besançon (FR)
(72) Inventeur: BALLANDRAS, Sylvain, F-25000 Besancon (FR); ULLIAC, Gwenn, F-25000 Besancon (FR); EDOUARD-GUICHARDAZ, Blandine, F-25870 Auxon-dessous (FR); BARON, Thomas, F-25030 Besancon Cedex (FR); RAUCH, Jean-Yves, 25770 Serre Les Sapins (FR)
(74) Mandataire: Lavoix
(86) Numéro de dépôt international: PCT/EP2012/069726
(87) Numéro de publication internationale: WO 2013/050533

(56) Documents cités:
- JP-A- 2001 044 794
- US-A1- 2003 098 632
- US-A1- 2006 066 175

## Description

La présente invention concerne des résonateurs à ondes de volume de type plan-plan, c'est-à-dire des lames de matériau piézoélectrique à surfaces planes métallisées, et des procédés de fabrication de ces résonateurs.

Les résonateurs à ondes de volume, tels que ceux présentés dans les documents US 2006/0066175 A1 et JP 2001-044794, sont largement utilisés dans de multiples applications telles que les filtres à fort couplage, les résonateurs à haute fréquence, les capteurs de température, d'accélération, les gyromètres, les capteurs de couple, les capteurs gravimétriques, les modulateurs acousto-optiques à fort confinement et à forte modulation.

Le document US 2003/098632 A1 divulgue un dispositif piézoélectrique et un procédé de fabrication de ce dispositif, qui comporte notamment une étape de découpe du matériau piézoélectrique brut, de préférence par sciage. Ce document envisage que la rugosité des faces du matériau piézoélectrique peut être inférieure à 0,1 nm.

La recherche de procédés pour fabriquer un nombre élevé de résonateurs à ondes de volume de façon collective sur une plaque monocristalline reste un sujet d'actualité.

Les procédés développés jusqu'à présent consistent essentiellement à exploiter des méthodes de rodage/polissage de plaques, éventuellement collées à plat sur un substrat de soutien.

Cette approche est certes très efficace mais ne permet pas de maîtriser facilement des épaisseurs de plaques inférieures à 10µm.

Le problème technique est donc d'améliorer la fabrication de plaques d'épaisseurs inférieures à 10µm, ou en d'autres termes d'améliorer le rendement de fabrication de résonateurs à ondes de volume de type plan-plan sur une même tranche de mono cristal.

De manière connexe, un autre problème technique est également d'améliorer l'intégration des plusieurs résonateurs à ondes de volume de type plan-plan sur une même tranche de mono cristal.

A cet effet, l'invention a pour objet un résonateur piézoélectrique à ondes de volume fonctionnant à une fréquence prédéterminée et un procédé de fabrication d'un tel résonateur selon les revendications.

L'invention sera mieux comprise à la lecture de la description de plusieurs formes de réalisation qui va suivre, donnée uniquement à titre d'exemple et faite en se référant aux dessins sur lesquels :
- la Figure 1 est une vue d'une première forme de réalisation d'un résonateur à ondes de volume dans lequel le bloc de substrat et la plaque résonnante sont d'un seul tenant ;
- la Figure 2 est une coupe transversale du résonateur de la Figure 1 dans le sens de l'épaisseur de la plaque résonnante suivant le plan de coupe II-II de la Figure 1 ;
- la Figure 3 est une coupe transversale dans le sens de l'épaisseur de la plaque résonnante d'une deuxième forme de réalisation dérivée d'un résonateur à ondes de volume de la Figure 1 dans lequel un goulet d'étranglement sépare la plaque du bloc de substrat ;
- la Figure 4 est une coupe transversale dans le sens de l'épaisseur de la plaque résonnante d'une troisième forme de réalisation de résonateur, dérivée du résonateur de la Figure 1, qui met en oeuvre une métallisation accrue au niveau des électrodes sur la partie haute du substrat.
- la Figure 5 est une coupe transversale dans le sens de l'épaisseur de la plaque résonnante d'une quatrième forme de réalisation d'un résonateur à ondes de volume, de forme géométrique identique à celle du résonateur de la Figure 1, dans lequel un élément de fixation relie la plaque résonnante au bloc de substrat ;
- la Figure 6 est une coupe transversale dans le sens de l'épaisseur de la plaque résonnante d'une cinquième forme de réalisation d'un résonateur à ondes de volume, de forme géométrique identique à celle du résonateur de la Figure 1, dans lequel un élément d'isolation acoustique relie la plaque résonnante au bloc de substrat ;
- la Figure 7 est un ordinogramme d'un procédé de fabrication du résonateur de la Figure 1 ;
- la Figure 8 est une vue d'un premier état intermédiaire du résonateur de la Figure 1 fabriqué par le procédé de la Figure 7 ;
- la Figure 9 est une vue d'un deuxième état intermédiaire du résonateur de la Figure 1 fabriqué par le procédé de la Figure 7 ;
- la Figure 10 est une vue d'un troisième état intermédiaire du résonateur de la Figure 1 fabriqué par le procédé de la Figure 7 ;
- la Figure 11 est une vue d'une puce intégrant sur un même substrat un ensemble de plusieurs résonateurs décrits dans les Figures 1 à 6 ;
- la Figure 12 est un ordinogramme d'un procédé de fabrication du résonateur de la Figure 5 ou de la Figure 6;
- la Figure 13 est une vue d'un premier état intermédiaire du résonateur de la Figure 5 ou de la Figure 6 fabriqué par le procédé de la Figure 12 ;
- la Figure 14 est une vue d'un deuxième état intermédiaire du résonateur de la Figure 5 ou de la Figure 6 fabriqué par le procédé de la Figure 12 ;
- la Figure 15 est une vue d'un troisième état intermédiaire du résonateur de la Figure 5 ou de la Figure 6 fabriqué par le procédé de la Figure 12 ;

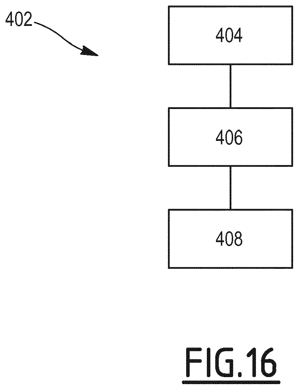

- la Figure 16 est un ordinogramme d'un procédé de fabrication généralisant les procédés de fabrication 7 et 12.

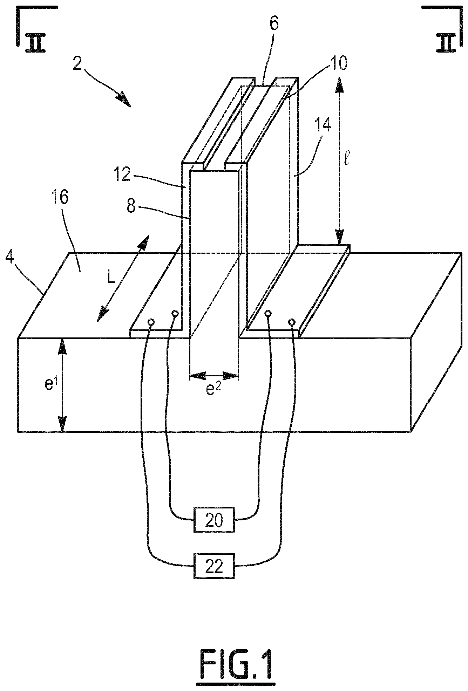

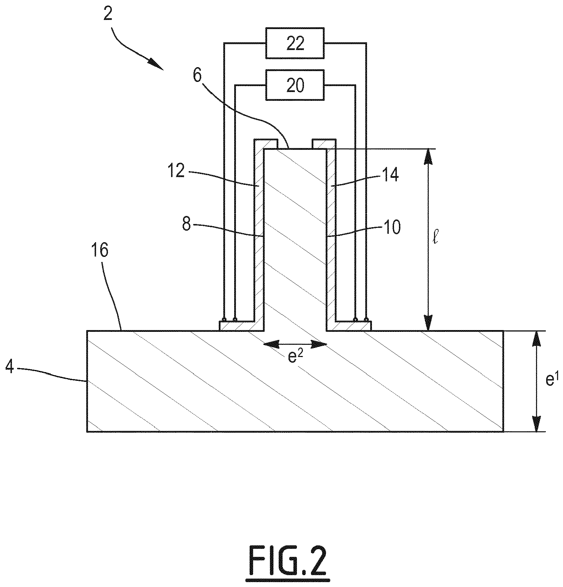

Suivant les Figures 1 et 2, un résonateur 2 à ondes de volume et à mode d'excitation piézoélectrique, configuré pour fonctionner à une fréquence désirée prédéterminée, comprend un bloc de substrat 4, une plaque résonnante 6 ayant une première face 8 et une deuxième face 10 en vis-à-vis, une première électrode métallique 12 déposée sur la première face 8 et une deuxième électrode métallique 14 déposée sur la deuxième face 10 de la plaque résonnante 6.

Le bloc de substrat 4, constitué en un premier matériau, comporte une face plane 16 possédant une première épaisseur e1 suivant une normale de la face plane 16 et sert de support à la plaque résonnante 6.

La plaque résonnante 6, constituée en un deuxième matériau piézoélectrique, est délimitée par les première et deuxième faces planes 12, 14. Les deux faces 12, 14 de la plaque 6 sont mutuellement parallèles et espacées d'une distance désignée par e2, laquelle distance forme l'épaisseur de la plaque résonnante 6.

Chaque face 12, 14 de la plaque résonnante 6 possède une longueur L et une largeur I et une deuxième épaisseur e2, et,

Ici, le premier matériau et le deuxième matériau sont identiques. Par exemple, les premier et deuxième matériaux sont du niobate de lithium.

Suivant les Figure 1 et 2, la plaque résonnante 6 et le bloc de substrat 4 forment une pièce unique d'un seul tenant.

Les première et deuxième électrodes métalliques 12, 14 recouvrent au moins en partie et respectivement la première face 8 et la deuxième face 10 de la plaque résonnante 6. Pour réaliser l'excitation des ondes de volume au sein de la plaque résonnante 6, une partie au moins des surfaces des deux électrodes 12, 14 se superposent au travers de la plaque 6.

L'idée sous-jacente qui a conduit à la conception du résonateur de la Figure 1 consiste à amincir d'une manière ou d'une autre un bloc brut de substrat de forme initiale globalement parallélépipédique et enveloppant la plaque, selon des dimensions latérales, c'est-à-dire ici l'épaisseur du substrat, pour réaliser un résonateur sous forme d'une plaque ou barreau attaché perpendiculairement au substrat.

Selon cette idée, toutes les coupes de matériaux cristallins piézoélectriques utilisables pour les applications d'ondes de volume peuvent être exploitées en tenant compte du fait que l'orientation cristalline de référence pour l'application du résonateur est celle définie par les plans d'extensions des deux faces de la plaque résonnante.

Ici, suivant les Figures 1 et 2, à titre d'exemple, la plaque résonnante est découpée suivant une coupe notée selon le standard IEEE Std-176 Révision 1949 par (YXI)/38° dans un substrat brut, prédécoupé suivant une coupe de niobate de lithium notée (YXI)/128°. La découpe de la plaque résonnante est effectuée en supposant que l'excitation électrique est appliquée entre les deux faces de flanc de la plaque et le sens de propagation des ondes de volume est dirigé suivant la normale aux deux faces de la plaque. La plaque fait 5µm d'épaisseur e2 et 25µm de largeur l.

La coupe (YXI)/128° du substrat brut est choisie d'une part pour sa disponibilité car c'est un standard pour le niobate de lithium, et pour la proximité de sa coupe orthogonale (YXI)/38° avec une coupe particulièrement favorable pour les ondes de volume, la coupe (YXI)/36°. Sur cette coupe (YXI)/36°, seul le mode longitudinal est couplé avec un maximum de couplage électromécanique kₛ² de 20%.

La plaque ainsi usinée sur une coupe de niobate de lithium (YXI)/128° formant substrat équivaut donc à une configuration de résonateur à ondes de volume sur coupe (YXI)/38°, soit les 128° plus ou moins une rotation de 90° par construction, qui nous place très proche de l'optimum à (YXI)/36°.

Il est à remarquer que lorsque le facteur de forme de la plaque, désigné par FI et égal au rapport de la largeur de la plaque l sur la deuxième épaisseur, est de faible valeur, ici égal à 5, la structure considérée est notablement pénalisée par un mode parasite à 660 MHz de faible coefficient de qualité qui perturbe le mode longitudinal considéré seul utile dans le cadre de l'application du résonateur.

Afin d'améliorer cet état de fait plusieurs solutions existent.

Une première solution consiste à allonger la largeur l de la plaque pour favoriser l'établissement du mode longitudinal résonnant utile entre les deux faces et minimiser la partie d'énergie acoustique au voisinage du bloc de substrat.

Cette solution s'avère très efficace et de meilleurs résultats, en termes d'une résonance du mode longitudinal très bien résolue et très pure en réponse spectrale, sont obtenus lorsque par exemple le facteur de forme FI est égal à 15, ce cas correspondant à une épaisseur e2 de 5µm et une largeur l de 75µm.

Avec ce facteur de forme plus élevé, le couplage électromécanique est toujours de 19% et le coefficient de qualité augmente pour le mode longitudinal.

Lorsque le facteur de forme FI est encore plus élevé, par exemple égal à 200, la pureté spectrale du résonateur est améliorée. Pour un bloc de substrat en niobate de lithium coupé suivant la coupe YXlt/126°/90°, une résonance particulièrement marquée avec un couplage légèrement supérieur à 20% est obtenue.

Ainsi, lorsque le facteur de forme FI est suffisamment élevé, le coefficient de qualité de la résonance n'est limité que par les propriétés intrinsèques du matériau constituant la plaque résonnante seule et non par les effets de perte par rayonnement acoustique dans le bloc de substrat.

Le deuxième matériau constituant la plaque résonnante est compris dans l'ensemble des matériaux formé par le niobate de lithium, le tantalate de lithium, le niobate de potassium, les céramiques piézoélectriques, le quartz, le tétraborate de lithium, l'orthophosphate, de gallium, le langasite, la langatate, le langanite.

En variante, le matériau piézoélectrique de la plaque résonnante, sa coupe cristallographique et son épaisseur sont choisis pour permettre la création et l'entretien par la plaque d'ondes de volume se propageant dans le sens de l'épaisseur de la plaque et de polarisation transversale.

A titre d'exemple, dans le cas de l'exploitation de la coupe AT du quartz, notée selon le standard IEEE Std-176 Révision 1949 par (YXI)/36°, la découpe de la plaque sera effectuée à partir d'un bloc brut de quartz formant le substrat prédécoupé selon une tranche de coupe notée (YXI)/126° ou encore (YXI)/-54°.

De manière générale, la plaque résonnante est fixée perpendiculairement au voisinage de la face plane du bloc de substrat de sorte que la largeur de la plaque résonnante et la première épaisseur du bloc de substrat ont un même sens.

De manière générale le premier matériau, le deuxième matériau, la première épaisseur e1 du bloc de substrat, la longueur L, la largeur l, la deuxième épaisseur e2 de la plaque résonnante 6 sont configurés pour piéger des ondes de volume à la fréquence de fonctionnement du résonateur et pour réaliser un résonateur piézoélectrique à ondes de volume de type plan-plan, c'est-à-dire des ondes de volumes se propageant dans le sens de l'épaisseur de la plaque résonnante.

En fonctionnement, le résonateur est branché en sortie d'une source d'excitation électrique 20 et en entrée d'un circuit d'extraction 22 d'un signal utile à la fréquence de résonance et de travail f, le circuit d'extraction 22 formant une charge de sortie.

La source d'excitation électrique 20, branchée entre la première électrode 12 et la deuxième électrode 14, est configurée pour générer un signal de tension ayant une composante sinusoïdale dominante à la fréquence de travail f.

Le circuit d'extraction 22, branché également entre la première électrode 12 et la deuxième électrode 14, est configuré pour extraire un signal utile à la fréquence de travail f.

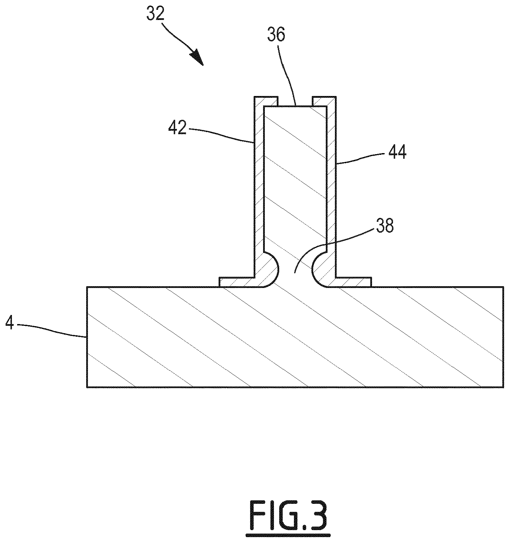

Suivant la Figure 3, un deuxième mode de réalisation de résonateur 32, dérivé du résonateur 2 de la Figure 1 comprend une plaque résonnante fixée d'un seul tenant au bloc de substrat.

Les matériaux utilisés et les dimensions géométriques de la plaque résonnante et du bloc de substrat en termes d'épaisseur e1, de longueur L et de largeur l sont identiques à ceux du résonateur 2 de la Figure 1.

La plaque résonnante, ici désignée par la référence numérique 36, présente une zone d'étranglement 38 en épaisseur de plaque dans le sens de la largeur l sur toute sa longueur L.

Dans la zone d'étranglement 38, située au voisinage de la face plane 16 du bloc de substrat 4, l'épaisseur de la plaque 36 varie et passe par un minimum.

L'amincissement de la plaque formée par la zone d'étranglement 38, utilisé à la base de la plaque résonnante 36, permet d'isoler au mieux la zone de vibration maximale à l'intérieur de la plaque 36 encastrée dans le substrat 4.

Dans ce mode de réalisation, cette structure est dénommée structure à bottle-neck ou à goulot d'étranglement par analogie avec la forme resserrée d'un goulot de bouteille.

Cette structure a été validée pour un facteur de forme FI de 15 comme envisagé pour le résonateur de la Figure 1, c'est-à-dire une largeur l de la plaque de 75 µm pour une épaisseur e2 de 5 µm.

Des première et deuxième électrodes 42, 44 recouvrent chacune une face différente de la plaque 36 et remplissent au pied de la plaque la dépression formée par la zone d'étranglement de la plaque.

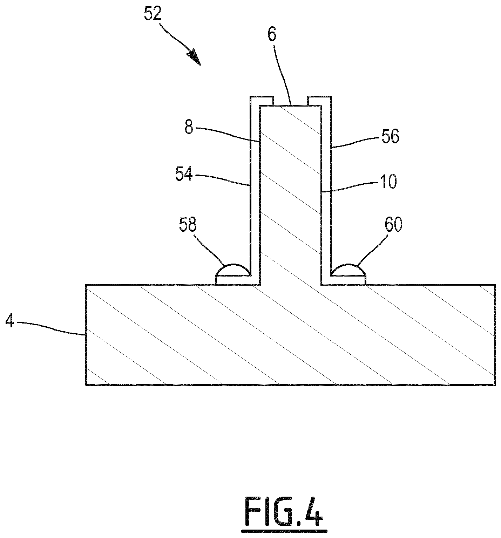

Suivant la Figure 4, un troisième mode de réalisation de résonateur, dérivé de la du résonateur 2 de la Figure 1, met en oeuvre une métallisation accrue au niveau des électrodes sur la partie haute du substrat.

Dans ce mode de réalisation seules les première et deuxième électrodes, désignées par les références numériques 54 et 56, diffèrent des électrodes 12 et 14 du résonateur 2 de la Figure 1 en ce qu'elles comprennent chacune un bourrelet différent 58, 60, c'est à dire un supplément de métal.

Les électrodes 54, 56 sont configurées au travers de cet ajout de métal pour obtenir un effet de masse sur la partie haute du substrat et localiser le maximum de l'amplitude de la vibration acoustique loin de l'encastrement de la plaque 6 au substrat 4.

En variante cet effet de masse peut également être obtenu par dopage de la partie haute du substrat. Pour la plupart des matériaux monocristallins, il existe des méthodes de dopage permettant de substituer, voire d'intégrer au sein de la maille des atomes étrangers à la structure cristalline pour modifier localement les propriétés de la matière.

Une méthode particulièrement utilisée en optique avec le niobate de lithium concerne l'échange protonique qui permet la diffusion d'atomes légers (hydrogène, titane etc.) au sein du réseau cristallin avec ou sans modifications structurelles. Cette méthode est décrite par exemple dans l'article de Toshiaki Suhara, Shuji Fujiwara et Hiroshi Nishihara intitulé « Proton-exchanged Fresnel lenses in TiLiNbO3 waveguides », Applied Optics, Vol. 25, Issue 19, pp.3379-3383 (1986).

On peut également substituer des atomes plus lourd (Erbium, MgO, etc.) au sein de la maille cristalline par diffusion à haute température. Un tel procédé est décrit dans la thèse de Arnaud Grisard intitulée « Lasers guides d'ondes dans le niobate de lithium dopé en Erbium », Université de Nice-Sophia Antipolis, U.F.R. Faculté des Sciences, 1997. Il est ainsi possible de modifier localement les propriétés élastiques par modification de la densité de masse et ainsi créer les conditions de guidage requises en fonction de l'orientation cristalline choisie.

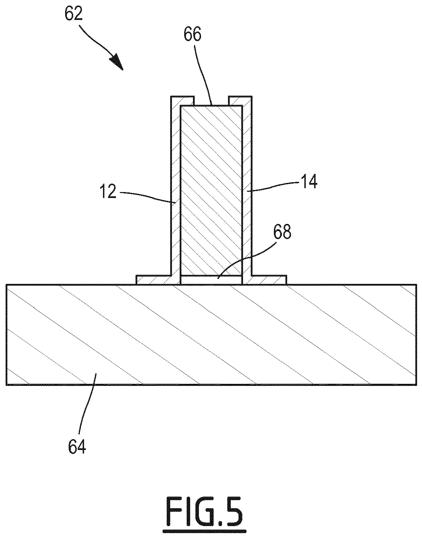

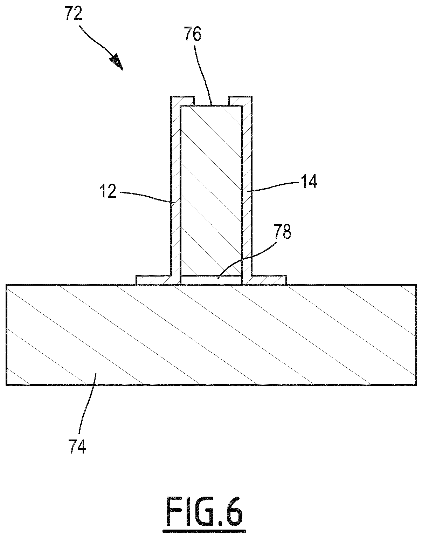

Suivant les Figures 5 et 6, d'autres structures de résonateurs permettent d'améliorer le piégeage de l'onde de volume dans la plaque résonnante.

Suivant la Figure 5, une quatrième forme de réalisation de résonateur 62 comprend un bloc de substrat 64 et une plaque résonnante 66 dont les matériaux sont différents.

Le matériau de la plaque résonnante 66 possède des propriétés piézoélectriques.

La forme et les dimensions géométriques du bloc de substrat 64 et de la plaque 66 sont identiques à celles du bloc de substrat 4 et de la plaque résonnante 6 de la Figure 1.

Suivant la Figure 5, le bloc de substrat 64 et la plaque résonnante 66 sont des pièces distinctes reliées entre elles par un élément de liaison 68 comme par exemple ici un joint de colle transparent acoustiquement. Un joint de colle peut être compris comme une couche polymère, déposée par exemple par centrifugation, et réticulée pour créer une liaison solide entre le matériau de la plaque 66 et le matériau du bloc de substrat 64, ou encore des couches métalliques, déposées sur les faces à coller et utilisées pour un report par diffusion inter-métallique, Au, In, Cu étant les matériaux les plus utilisés à cette fin, dans la mesure où ces couches ne viennent pas court-circuiter les électrodes en regard déposées sur les faces de flancs de la plaque résonante 66, ou encore des couches de silice déposées sur les faces à coller et activée de sorte que leur caractère hydrophile permette un collage moléculaire tel que mis en oeuvre pour les substrats dit de SOI (Silicon-On-Insulator, TM SOITEC).

Le premier matériau du bloc de substrat 64 est choisi de sorte que les vitesses de propagation des ondes de volume s'y propageant sont supérieures à celles du deuxième matériau.

Par exemple, le deuxième matériau constituant la plaque résonnante 66 est du niobate ou du tantalate de lithium, du quartz, de la langasite ou tout autre matériau piézoélectrique monocristallin, déposé sur une couche de carbone de diamant, ou le cas échéant plus simplement sur silicium ou saphir constituant le premier matériau du bloc de substrat.

Suivant la Figure 6, un cinquième mode de réalisation de résonateur 72, dérivé du résonateur de la Figure 5, comprend un bloc de substrat 74 et une plaque résonnante 76 dont les matériaux sont identiques.

Le résonateur 72 comprend un élément d'isolement acoustique 78, disposé entre le bloc de substrat 74 et la plaque résonnante 76, et fixé à ces derniers par deux joints de colle non représentés sur la Figure 6.

L'élément d'isolement acoustique 78 est ici un miroir de Bragg, réalisé ici par un empilement de couches d'impédances acoustiques très contrastées.

Les couches d'impédances acoustiques très contrastées sont par exemple des couches de nitrure d'aluminium ou de nitrure de silicium et d'oxyde de silicium, l'empilement étant configuré pour réfléchir en phase et complètement les ondes de volume aux fréquences de travail envisagées.

En variante, le premier matériau constituant le substrat et le deuxième matériau constituant la plaque sont différents.

Les modes de réalisation des Figures 5 et 6 peuvent être généralisés en considérant que le résonateur comprend un élément de fixation et/ou d'isolation acoustique, distinct du bloc de substrat et de la plaque résonnante, constitué en au moins un troisième matériau distinct des premier et deuxième matériau, l'élément de fixation et/ou d'isolation acoustique étant compris dans l'ensemble constitué par une unique couche de colle, un miroir de Bragg formé d'un empilement de couches à impédances acoustiques contrastées.

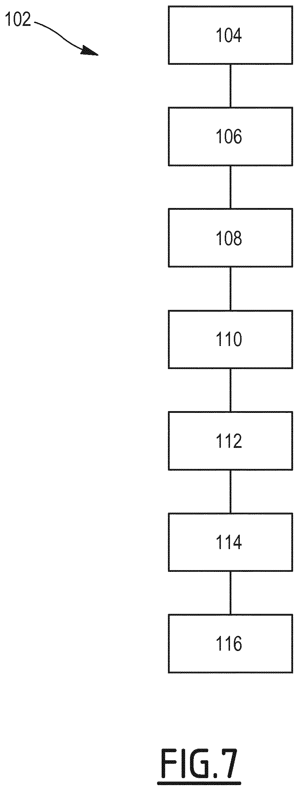

Suivant la Figure 7, un procédé 102 complet de réalisation d'un résonateur de la Figure 1, comportant au moins une plaque résonnante reliée d'un seul tenant et montée perpendiculairement sur un bloc de substrat, comprend une série d'étapes 104, 106, 108, 110, 112, 114, 116.

Les étapes de micro-fabrication sont applicables pour n'importe quelle coupe de niobate de lithium ou tantalate de lithium.

Ici le matériau brut de départ du procédé est une tranche de niobate de litihium dénommée en anglais « wafer ».

De manière générale, sous couvert de déterminer les conditions de sciage appropriées, le procédé est applicable à tout matériau monocristallin, en particulier piézoélectrique.

L'utilisation d'une lame capable de polir les faces en même temps que la découpe offre la possibilité de réaliser des faces compatibles avec l'excitation et la réflexion d'ondes de volume efficaces au sens de la qualité de résonance. La surface résultante doit présenter une rugosité de quelques dizaines à quelques nanomètres RMS (en anglais Root Mean Square), idéalement un poli optique. En tout état de cause, une rugosité des surfaces du résonateur supérieure à 100 nm RMS n'est pas compatible avec une qualité de la résonance conforme au standard de l'acousto-électricité.

L'utilisation d'une scie de précision, par exemple une scie de marque Disco ® permet en deux traits de scie de définir les deux plans des faces de la plaque résonante.

La résolution en épaisseur e2 d'une plaque résonnante est définie par la précision d'alignement entre ces deux traits de scie et peut atteindre 1 µm dans le meilleur des cas.

La largeur l de la plaque résonnante est définie, quant à elle, par la profondeur de coupe demandée dans le sens de l'épaisseur du bloc du substrat formé par la tranche de niobate de lithium et peut atteindre plusieurs centaines de µm.

Dans une première étape 104, une tranche de niobate de litihium est fournie dont la coupe de départ est notée (YXwl)ϕ/θ+90° dans le sens de l'épaisseur avec une première face supérieure et une deuxième face inférieure.

Dans une deuxième étape 106, la face supérieure de la tranche de niobate de lithium est enduite d'une résine, par exemple de la résine S 1828 de marque Shipley. Le dépôt de la résine est effectué par exemple par un procédé de type Revêtement par Rotation Centrifuge (en anglais spin coating) sur une épaisseur de 2,5 µm. Dans la même étape 106, la résine est recuite en étuve pendant une heure à 95° Celsius afin d'évaporer les solvants et de la rendre ainsi plus résistante à l'étape de découpe par la scie.

Dans une troisième étape 108, une plaque ou plusieurs plaques résonnantes sont découpées. Pour configurer le sciage d'une plaque, ici quatre traits de scie sont requis au moins afin de réaliser la plaque. En effet, la largeur de la lame de la scie étant de 200 µm, deux traits de scie superposés sont réalisés afin d'obtenir un espace accessible de 350-400 µm de part et d'autre de la plaque pour permettre des tests sous pointes.

Lors de la troisième étape 108, l'épaisseur e2 et la largeur l d'au moins une plaque sont définies par la profondeur des découpes et la précision d'alignement entre les séries de deux traits de scie ainsi que la largeur des électrodes par la superposition de deux traits de scie.

Une fois la troisième étape 108 réalisée, dans une quatrième étape 110 au moins une bande dans le sens de la longueur sur chaque face libre de sommet des plaques ainsi que des bandes dans le sens de la longueur sur des faces de plancher du substrat situées entre des plaques sont recouverts par la résine de protection S 1828.

Dans une cinquième étape 112, des électrodes métalliques sont déposées sur les faces latérales, c'est-à-dire les flancs des plaques, ainsi qu'au fond des tranchées de largeur comprise entre 350-400 µm sur une longueur L pouvant atteindre plusieurs centimètres.

Afin de recouvrir les flancs d'une plaque ou d'une série de plaques formant un créneau sur une largeur l pouvant atteindre plusieurs centaines de µm, un dépôt d'aluminium est réalisé par pulvérisation cathodique en trois fois en basculant la puce, formée par le substrat et les plaques, par exemple deux fois de 45° autour d'un axe orienté dans le sens de la longueur L des plaques.

Dans cette cinquième étape 112, la puce entière est recouverte par la couche d'aluminium et les électrodes sont alors obtenues par la technique dite du en anglais du lift-off, c'est-à-dire du décollement. Pour cela, la puce est plongée dans un bain de solvant (en anglais remover), par exemple le remover 1165, solution chimique dissolvant la résine de protection, ici la résine S 1828, chauffé à 70° pendant plusieurs heures.

Le lift-off est ensuite accéléré et achevé par l'utilisation d'un bain à ultra-sons pendant une minute. Cette étape permet en particulier d'éliminer la résine localisée sur la crête de la plaque et d'isoler les électrodes déposées sur les faces en regard de la plaque résonnante.

Ensuite dans une sixième étape 114, afin de solidifier les plaques ou barreaux avant une septième étape 116 de découpe longitudinale des plaques résonnantes, les plaques ou barreaux sont enduits d'une résine de protection S1805 à l'aide de la technique de revêtement par pulvérisation, dénommée en anglais spray-coating. Cette sixième étape 114 permet de recouvrir de résine, les tranches de niobate structurées, c'est-à-dire dire les puces munies de leurs électrodes.

La septième et dernière étape 116 consiste à définir la longueur L des plaques ou barreaux par découpe à la scie, par exemple ici dans notre cas une longueur L de 500 µm. Cette septième étape 116 est assez critique et peut entraîner la casse donc la perte de nombreuse plaques. En effet, il s'agit ici de faire des traits de scie perpendiculaires à une surface crènelée tous les 500 µm suivant le sens de la longueur L et sur une profondeur supérieure à la première profondeur de découpe, c'est-à-dire la largeur I des plaques, afin de rendre électriquement indépendante chaque puce élémentaire ainsi formée.

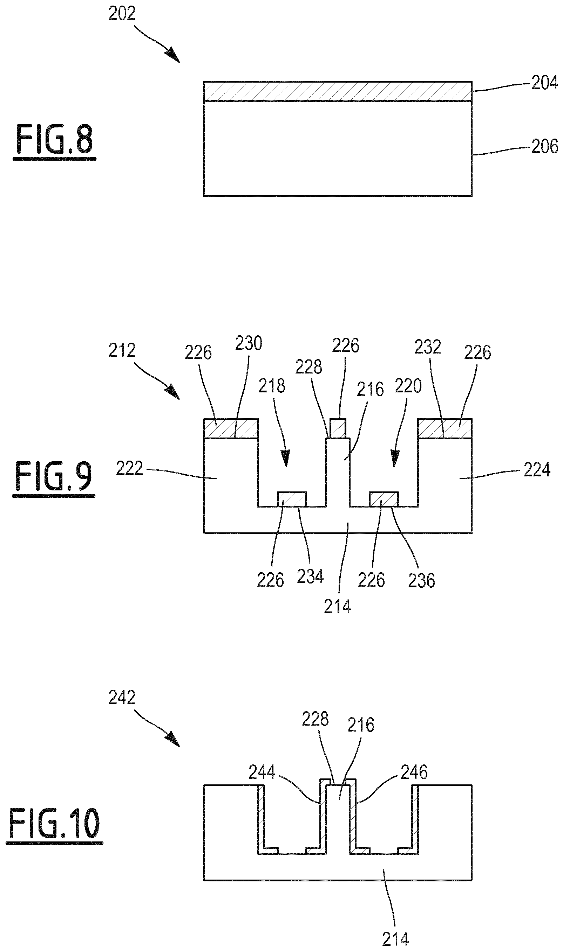

Suivant la Figure 8, un premier état intermédiaire 202 du résonateur 2 de la Figure 1, obtenu à la fin de la deuxième étape 106 du procédé 102, est un empilement d'une couche 204 de résine S1828 et d'une tranche brute 206 de niobate de lithium.

Suivant la Figure 9, un deuxième état intermédiaire 212 du résonateur de la Figure 1 fabriqué par le procédé 102, obtenu à la fin de la troisième étape de sciage 108 comprend un bloc de substrat dans lequel a été usiné une plaque 216, entourée de part et d'autre d'un creux ou d'une vallée nue 218, 220, c'est-à-dire exposée. Deux barres 222, 224 d'extrémité du bloc 214 entourent la plaque 216 qui est ici unique. Une couche de résine 226 est déposée sur une face de sommet 228 de la plaque et sur des faces de sommet 230, 232 des barres 222, 224 ainsi que sur deux bandes de creux 234, 236 disposées de part et d'autre de la plaque 216.

Suivant la Figure 10, un troisième état intermédiaire 242 du résonateur de la Figure 1 fabriqué par le procédé 102, obtenu à la fin de l'étape de lift-off 112 de dépôt des électrodes est une puce structurée.

Ici, la puce 242 comprend une seule plaque résonante 216 avec deux électrodes 244, 246 en aluminium de part et d'autre de ses deux flancs, chaque électrode 244, 246 venant déborder légèrement sur la face de sommet 228 de la plaque 216 et sur une partie de la face de plancher du substrat 214 au pied de chaque flanc de la plaque résonante 216.

Cette structure après découpage des bords du substrat correspond à la structure du résonateur de la Figure 1.

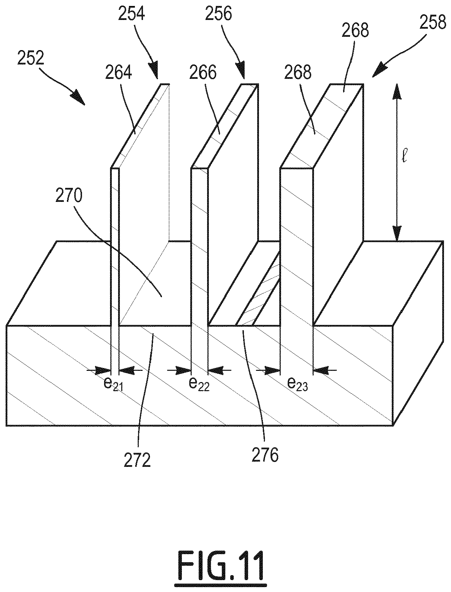

Suivant la Figure 11, une puce 252 formant un circuit complexe résonant, comprend trois résonateurs élémentaires 254, 256, 258 formés chacun par une plaque résonnante différente 264, 266, 268. Chaque plaque résonnante 264, 266, 268 de même largeur l présente une épaisseur différente e21, e22, e23.

Les deux premières plaques résonnantes 264, 266, représentées à gauche sur la Figure 11, sont couplées entre elles par la mise en commun d'une même électrode 270, réalisée par une liaison métallique déposée sur un plancher 272 de substrat commun.

Les deux premières plaques résonantes 264, 266 sont séparées électriquement de la troisième plaque 268 par une bande isolante 276.

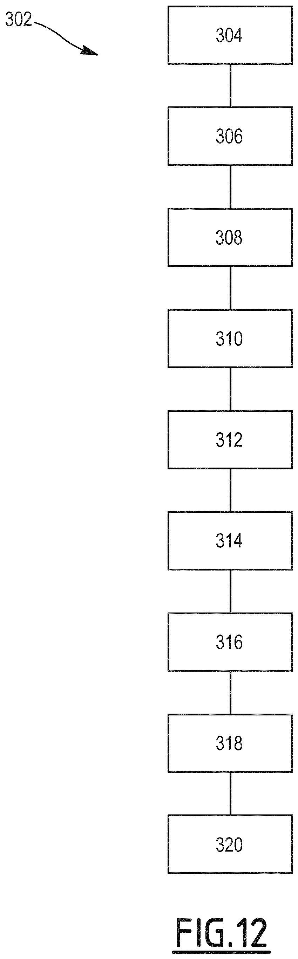

Suivant la Figure 12, un procédé 302 complet de réalisation d'un résonateur de la Figure 5 ou la Figure 6, comportant au moins une plaque résonnante, reliée au travers d'un moyen de fixation et/ou d'isolation acoustique en étant monté perpendiculairement sur un bloc de substrat, comprend une série d'étapes 304, 306, 308, 310, 312, 314, 316, 318, 320.

Ici, le moyen de fixation et/ou d'isolation acoustique est un miroir de Bragg, disposé entre la plaque résonante et le substrat. Le miroir de Bragg est réalisé ici par un empilement de couches d'impédances acoustiques très contrastées, des couches de nitrure d'aluminium ou de nitrure de silicium et d'oxyde de silicium par exemple, l'empilement étant configuré pour réfléchir en phase et complètement les ondes de volume aux fréquences de travail envisagées.

Dans une première étape 304, une tranche de niobate de litihium est fournie dont la coupe de départ est notée (YXwl)ϕ/θ+90° dans le sens de l'épaisseur avec une première face supérieure et une deuxième face inférieure.

Dans une deuxième étape 306, un miroir de Bragg est disposé sur la face supérieure du substrat de niobate de lithium, la surface du miroir ayant une envergure suffisante pour isoler un nombre important de plaques résonnantes.

Le miroir est réalisé ici par un empilement de couches d'impédances acoustiques très contrastées et de large étendue, des couches de nitrure d'aluminium ou de nitrure de silicium et d'oxyde de silicium par exemple, l'empilement étant configuré pour réfléchir en phase et complètement les ondes de volume aux fréquences de travail envisagées.

Le miroir de Bragg est fixé au substrat par un procédé de collage avec le dépôt au préalable d'un joint de colle. Ce miroir est alors constitué d'un empilement de matériaux reportés selon les procédés décrits pour la Figure 5 (collage polymère, diffusion métallique, collage moléculaire) et amincis pour atteindre des épaisseurs requises, qui peuvent varier notablement en fonction des fréquences de travail visées. Plus particulièrement, pour des applications radiofréquences, les épaisseurs de couches requises peuvent s'avérer compatibles des méthodes de dépôts assistées plasma, physiques ou chimiques, en phases solides ou vapeurs (évaporation, pulvérisation cathodique, dépôt sous phases vapeurs chimiques, jets moléculaires etc.), donnant lieu à des empilements de couches de quelques micromètres à une fraction de µm d'épaisseur chacune. Il est ainsi loisible de réaliser des couches multiples présentant des épaisseurs maîtrisées et donnant lieu à un miroir de grande efficacité de réflexion, proche de celle d'une lame d'air.

Dans une troisième étape 308, une couche d'un transducteur piézoélectrique est déposée sur le miroir de Bragg. L'orientation cristallographique du transducteur est choisie de sorte que lorsque la couche est découpée selon le sens de l'épaisseur du substrat par deux plans parallèles entre eux et de direction normale convenablement choisie, le coefficient de couplage électroacoustique est élevé favorable à la création et au maintien d'ondes acoustique de volume entre les plans de coupes du transducteur.

Ici, on suppose que le matériau est le même que le matériau du substrat, c'est-à-dire en niobate de lithium, et que les orientations cristallographiques sont les mêmes lors de l'empilement. Ainsi, la coupe de transducteur électrique est (YXwl)ϕ/θ+90° étant considéré q'une coupe (YXwl)ϕ/θ lors du découpage des plaques présente un fort coefficient de couplage électroacoustique compatible de l'application recherchée, c'est-à-dire fort pour le filtrage large bande, soit supérieur à 5%, intermédiaire ou même modéré pour les applications de filtres à bande étroite ou résonateur, soit compris entre 5% et 0,0001.

Par exemple, la tranche brute de départ ou wafer est coupée en deux parties égales, une première partie servant de substrat, une deuxième partie servant de transducteur.

La fixation de la couche de transducteur sur le miroir de Bragg est réalisée à l'aide d'un joint de colle par exemple.

Dans une quatrième étape 310, analogue à la deuxième étape 106 du procédé 102, la face supérieure de la tranche de niobate de lithium formant le transducteur est enduite d'une résine, par exemple de la résine S 1828 de marque Shipley. Le dépôt de la résine est effectué par exemple par un procédé de type Revêtement par Rotation Centrifuge (en anglais spin coating) sur une épaisseur de 2,5 µm. Dans la même étape la résine est recuite en étuve pendant une heure à 95° Celsius afin d'évaporer les solvants et de la rendre ainsi plus résistante à l'étape de découpe par la scie.

Dans une cinquième étape 312, analogue à la troisième étape 108 du procédé 102, une plaque ou plusieurs plaques sont découpées dans l'empilement suivant des plans parallèles dont la direction correspond à la coupe souhaitée (YXwl)ϕ/θ

Pour configurer le sciage d'une plaque résonnante, ici quatre traits de scie sont requis au moins afin de réaliser la plaque. En effet, la largeur de la lame de la scie étant de 200 µm, deux traits de scie superposés sont réalisés afin d'obtenir un espace accessible de 350-400 µm de part et d'autre de la plaque pour permettre des tests sous pointes.

Lors de la cinquième étape 312, l'épaisseur e2 et la largeur l d'au moins une plaque sont définies par la profondeur des découpes et la précision d'alignement entre les séries de deux traits de scie ainsi que la largeur des électrodes par la superposition de deux traits de scie.

Une fois la cinquième étape 312 réalisée, une sixième étape 314, identique à la quatrième étape 110 du procédé 102 est réalisée.

Dans une septième étape 316, identique à la cinquième étape 112 du procédé 102, des électrodes métalliques sont déposées.

Ensuite dans une huitième étape 318, les plaques ou barreaux sont enduits d'une résine de protection S1805 à l'aide de la technique de revêtement par pulvérisation (dénommée en anglais spray-coating). Cette huitième étape permet de recouvrir de résine, les tranches de niobate structurées, c'est-à-dire dire les puces munies de leurs électrodes.

La neuvième et dernière étape 320 consiste à définir la longueur L des plaques ou barreaux par découpe à la scie, par exemple ici dans notre cas un longueur L de 500 µm.

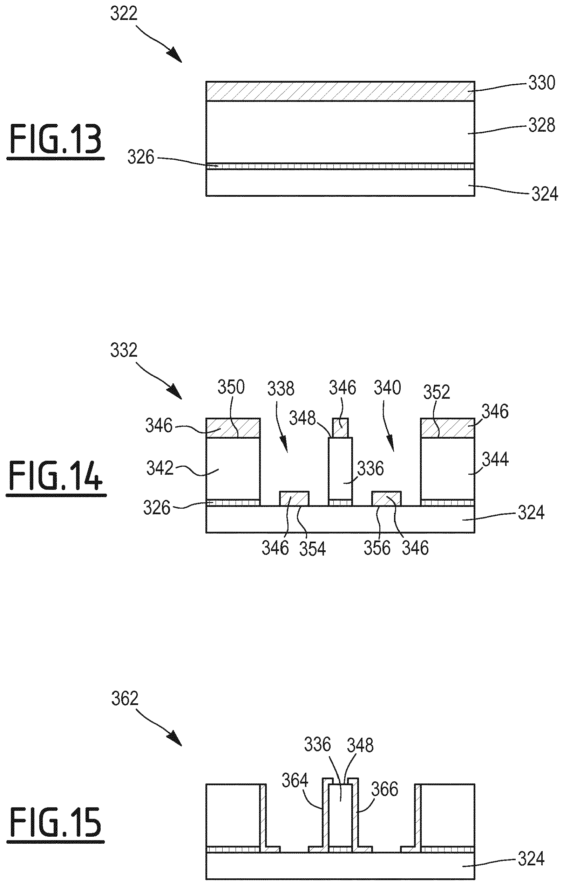

Suivant la Figure 13, un premier état intermédiaire 322 du résonateur de la Figure 5, obtenu à la fin de la deuxième étape 306 du procédé 302, est un empilement d'une première tranche brute 324 de niobate de lithium destinée à former le substrat porteur, d'une couche 326 formant un miroir de Bragg enserré dans deux joints de colle, d'une deuxième tranche brute 328 de niobate de lithium destinée à former au moins une plaque résonnante après usinage, et une couche 330 de résine S1828.

Suivant la Figure 14, un deuxième état intermédiaire 332 du résonateur de la Figure 5, obtenu à la fin de la troisième étape de sciage 308 comprend le bloc de substrat 324, une plaque 336 usinée dans l'ensemble des couches 326, 328, 330, entourée de part et d'autre d'un creux ou d'une vallée nue 338, 340, c'est-à-dire exposée. Deux barres 342, 344 d'extrémité de la puce 332 entourent la plaque 336 qui ici est unique. Une couche de résine 346 est déposée sur une face de sommet 348 de la plaque 336 et sur des faces de sommet 350, 352 des barres 342, 344 ainsi que sur deux bandes de creux 354, 356 disposées de part et d'autre de la plaque 336.

Suivant la Figure 15, un troisième état intermédiaire 362 du résonateur de la Figure 1, obtenu à la fin de l'étape de lift-off de dépôt des électrodes est une puce structurée.

Ici, la puce 362 comprend une seule plaque résonante 336 avec deux électrodes 364, 366 en aluminium de part et d'autre de ses deux flancs, chaque électrode 364, 366 venant déborder légèrement sur la face de sommet 348 de la plaque 336 et sur une partie de la face de plancher du substrat 324 au pied de chaque flanc de la plaque résonnante 336.

Cette structure après découpage des bords du substrat correspond à la structure du résonateur de la Figure 5.

De manière générale, un procédé de fabrication 402 d'un résonateur décrit dans les Figures 1 à 6 comprend trois étapes 404, 406, 408.

Dans une première étape 404, une couche brute de départ de plaque résonnante est fournie, la couche brute de départ de plaque résonante étant constituée en un matériau piézoélectrique, ayant une épaisseur de couche brute eb, et une étendue spatiale dans un plan perpendiculaire à la direction de l'épaisseur nettement plus grande que l'épaisseur eb de la couche brute, l'orientation cristallographique de la couche brute ayant été préalable choisie de sorte qu'il existe un plan de coupe cristallographique de la couche brute dans le sens de l'épaisseur eb pour lequel une tranche, découpée suivant le plan de coupe et ayant une épaisseur e2, réalise un résonateur piézoélectrique de type plan-plan à ondes de volume se propageant dans le sens de l'épaisseur de la tranche, avec un coefficient de couplage électro-acoustique compatible de l'application recherchée, c'est-à-dire fort pour le filtrage de bandes intermédiaire ou large, soit supérieur à 5%, intermédiaire ou même modéré pour les applications de filtres à bande étroite ou résonateur, soit compris entre 5% et 0,0001.

Dans une deuxième étape 406, une plaque résonnante est découpée dans le sens de l'épaisseur de la couche brute et partiellement ou totalement dans la couche brute de départ de plaque résonnante, la plaque résonnante ayant une épaisseur de plaque résonante e2, une première et une deuxième faces planes disposées en vis-à-vis, les faces planes possédant une longueur L, une largeur l et, la découpe étant effectuée par un procédé d'usinage suivant la direction de plan de coupe, la largeur l de la plaque et l'épaisseur de la couche brute étant de même sens, le matériau et l'orientation cristallographique de la couche brute, la direction du plan de coupe, la longueur L, la largeur l, la deuxième épaisseur de la plaque résonnante étant configurés pour piéger des ondes de volume à la fréquence de fonctionnement du résonateur et pour réaliser un résonateur piézoélectrique à ondes de volume de type plan-plan, c'est-à-dire des ondes de volumes se propageant dans le sens de l'épaisseur de la plaque résonnante.

Dans une troisième étape 408, une première et une deuxième électrodes métalliques sont déposées recouvrant au moins en partie et respectivement la première face et la deuxième face de la plaque résonnante. Les surfaces respectives des première et deuxième électrodes sont au moins partiellement en vis-à-vis au travers de la plaque résonante.

Les applications utilisées des résonateurs décrits ci-dessus sont les suivantes :
- les résonateurs pour les sources de fréquence RF ;
- les résonateurs, éléments d'impédances pour les filtres de fréquence en réseau (à échelle ou à treillis) ;
- les résonateurs couplés pour des filtres de fréquence polaire (en jouant sur la frange spécifique des barreaux en y intégrant une découpe ou une surcharge massique localisée pour créer des conditions de couplage de modes) ;
- des résonateurs pour les capteurs et en particulier les capteurs sans fil interrogeables en bandes IFM (Industrielle - Scientifique - Médicale) ;
- des résonateurs pour les capteurs haute température (sur des matériaux tels que la langanite et ses dérivés, le GaPO₄, le ZnO ou l'AIN massif,...) ;
- des résonateurs pour des capteurs accélérométriques, gyroscopiques, gravimétriques ;
- des éléments pour la modulation de signaux optiques par couplage acoustico-optiques.

Les matériaux exploitables pour ces opérations sont le niobate, le tantalate de lithium et le niobate de potassium pour les filtres à fort couplage et (potentiellement les céramiques piézoélectriques et les monocristaux céramiques de type relaxeur), le quartz, le tétraborate de lithium, l'orthophosphate de gallium (GaPO₄), la langasite (La₃Ga₅SiO₁₄) et ses nombreuses variantes (langatate, langanite, etc.). ainsi que des matériaux plus délicats à élaborer sous forme monocristalline mais dont les propriétés piézoélectriques sont avantageuses pour les applications d'ondes élastiques de volume, soit el nitrue d'aluminium (AIN) ou l'oxyde de zinc (ZnO). Pour les capteurs et en particulier pour les capteurs haute température (électrodes adéquates choisies pour ce type d'application, soit le platine, l'iridium, le zirconium ou le rubidium ou tout autre électrode réputée robuste à la haute température obtenue par exemple par alliage des matériaux cités ci-dessus et éventuellement d'autres corps métalliques ou oxydes métalliques présentant des conductivités comparables à celles d'un métal idéal et une stabilité avérée desdites propriétés en fonction de la température), et de façon générale tout monocristal piézoélectrique disponible sous forme de plaque suffisamment épaisse (au minimum 200 µm sous forme brute, ou au minimum de quelques dizaines de microns si reporté sur un substrat selon les procédés décrits ci-dessus) pour permettre l'usinage des barreaux tels que présentés.

L'amélioration de la pureté spectrale passe également par une optimisation de géométrie transverse des barreaux, notamment par brisure des conditions de résonances radiales et élimination des modes barreaux par apodisation de la forme du barreau, celle-ci pouvant être faite sur la plaquette initiale par corrugation par exemple, ou usinage chimique afin d'éviter que les barreaux ne présentent une épaisseur homogène susceptible de favoriser lesdits modes.

Pour les niobate et tantalate de lithium, on peut réduire la sensibilité thermique des résonateurs en les recouvrant d'un dépôt de silice amorphe dont le coefficient de température de la fréquence est de signe positif et permet de compenser le signe négatif de celui de ces matériaux. Le dépôt peut être avantageusement réalisé au-dessus des électrodes, par exemple par pulvérisation cathodique, pour ne pas induire de capacité parasite dans le cas où le dépôt de silice aurait eu lieu avant métallisation.

Il convient de rappeler quelques exemples de coupe de matériaux les plus couramment utilisées pour les applications à ondes de volume :
- le Quartz : (YXI)/40° (plus ou moins 5°) pour l'utilisation de la coupe BT, (YXI)/- 54° (plus ou moins 5°) pour l'utilisation de la coupe AT, (YXwl)/22°/46° (plus ou moins 5° sur chaque angle) pour exploiter la coupe SC.
- le Niobate de lithium: (YXI)/126 (plus ou moins 5°) pour exploiter la coupe (YXI)/36° permettant la seule excitation d'une onde de volume longitudinale pure, (YXI)/73 (plus ou moins 5°) pour exploiter la coupe (YXI)/163° permettant la seule excitation d'une onde de volume de cisaillement pur, même orientations cristallines pour le tantalate de lithium.

Pour une surface donnée on peut ainsi multiplier le nombre de résonateurs de façon considérable selon au mois un facteur 10 en exploitant des coupes de monocristaux les plus avantageuses en termes de couplage électromécanique pour les applications aux filtres de fréquence, en termes de stabilité en température pour les applications aux sources stables de fréquence, en termes de sensibilité aux contraintes pour les applications aux capteurs, de manière générale en combinant ces diverses caractéristiques pour réaliser une fonction applicative donnée.

## Revendications

1. Résonateur piézoélectrique à ondes de volume fonctionnant à une fréquence prédéterminée et comprenant :
un bloc de substrat (4 ; 64 ; 74), porteur, ayant une face plane (16) possédant une première épaisseur e1 suivant une normale de la face plane et constitué en un premier matériau, et
une plaque résonnante (6 ; 36 ; 66 ; 76) ayant une première et une deuxième faces planes (8,10) disposées en vis-à-vis, possédant une longueur L, une largeur l et une deuxième épaisseur e2, et constituée en un deuxième matériau, ledit deuxième matériau étant piézoélectrique,
une première et une deuxième électrodes métalliques (12, 14 ; 42, 44 ; 54, 56) recouvrant au moins en partie et respectivement la première face (8) et la deuxième face (10) de la plaque résonnante (6 ; 36 ; 66 ; 76), et situées au moins partiellement en vis-à-vis au travers de la plaque résonante (6 ; 36 ; 66 ; 76),
la plaque résonnante (6 ; 36 ; 66 ; 76) étant fixée perpendiculairement au voisinage de la face plane (16) du bloc de substrat (4 ; 64 ; 74) de sorte que la largeur de la plaque résonnante (6 ; 36 ; 66 ; 76) et la première épaisseur du bloc de substrat (4 ; 64 ; 74) ont un même sens, et
le premier matériau, le deuxième matériau, la première épaisseur du bloc de substrat (4 ; 64 ; 74), la longueur, la largeur l, la deuxième épaisseur de la plaque résonnante (6 ; 36 ; 66 ; 76) étant configurés pour piéger des ondes de volume à la fréquence de fonctionnement du résonateur et pour réaliser un résonateur piézoélectrique à ondes de volume de type plan-plan, c'est-à-dire des ondes de volumes se propageant dans le sens de l'épaisseur de la plaque résonnante,
**caractérisé en ce que** les faces de la plaque résonante découpée par sciage sont des surfaces polies présentant une rugosité de quelques dizaines à quelques nanomètres RMS,
et **en ce que** le résonateur piézoélectrique comprend un élément de fixation et/ou d'isolation acoustique (68 ;78) à la fréquence de fonctionnement f, distinct du bloc de substrat (64 ;74) et de la plaque résonnante (66 ; 76), constitué en au moins un troisième matériau distinct des premier et deuxième matériaux, l'élément de fixation et/ou de d'isolation acoustique (68 ; 78) étant compris dans un ensemble constitué par une unique couche de colle et un miroir de Bragg formé d'un empilement de couches à impédances acoustiques contrastées.

2. Résonateur piézoélectrique à ondes de volume selon la revendication 1, dans lequel un facteur de forme latéral FI, défini comme le rapport de la largeur l de la plaque résonnante (6 ; 36 ; 66 ; 76) sur la deuxième épaisseur e2 de la plaque résonnante (6 ; 36 ; 66 ; 76), est supérieur ou égal à 5, de préférence supérieur ou égal à 10.

3. Résonateur piézoélectrique à ondes de volume selon l'une quelconque des revendications 1 à 2, dans lequel un facteur de forme longitudinal, défini comme le rapport de la longueur de la plaque résonnante (6 ; 36 ; 66 ; 76) sur l'épaisseur de la plaque résonnante (6 ; 36 ; 66 ; 76), est supérieur ou égal à 5, de préférence supérieur ou égal à 10.

4. Résonateur piézoélectrique à ondes de volume selon l'une quelconque des revendications 1 à 2, dans lequel la plaque résonnante (6) et le bloc de substrat (4) sont constitués en un même matériau piézoélectrique et forme une pièce d'un seul tenant.

5. Résonateur piézoélectrique selon l'une quelconque des revendications 1 à 4, dans lequel
la plaque résonnante (6 ; 76) et le bloc de substrat(4 ; 74) sont constitués en un même matériau piézoélectrique, et
la coupe cristallographique de la plaque résonnante (6 ; 76) suivant un plan parallèle à ses deux faces est choisie de sorte que le coefficient de couplage électroacoustique du transducteur formé par la plaque résonnante est supérieur à 0,0001 pour des ondes de volumes se propageant dans le sens de l'épaisseur de la plaque résonnante

6. Résonateur piézoélectrique selon l'une quelconque des revendications 1 à 5, **caractérisé en ce que** la plaque résonnante (36) présente une zone d'étranglement (38) dans la sens de l'épaisseur sur toute sa longueur pour laquelle l'épaisseur de la plaque résonnante (36) passe par un minimum, et la plaque résonnante (36) étant fixée au bloc de substrat (4), la zone d'étranglement (38) est située au voisinage de la face plane du bloc de substrat (4).

7. Résonateur piézoélectrique selon l'une quelconque des revendications 1 à 6, dans lequel
le premier matériau est compris dans l'ensemble des matériaux formé par le niobate de lithium, le tantalate de lithium, le niobate de potassium, les céramiques piézoélectriques, le quartz, le tétraborate de lithium, l'orthophosphate, de gallium, le langasite, la langatate, le langanite, l'oxyde de zinc et le nitrure d'aluminium.
le deuxième matériau est compris dans l'ensemble des matériaux formé par le niobate de lithium, le tantalate de lithium, le niobate de potassium, les céramiques piézoélectriques, le quartz, le tétraborate de lithium, l'orthophosphate, de gallium, le langasite, la langatate, le langanite, le carbone diamant, le silicium, le saphir.

8. Résonateur piézoélectrique selon l'une quelconque des revendications 1 à 7, dans lequel
les électrodes métalliques (12, 14 ; 42, 44 ; 54, 56) sont fabriquées dans un matériau compris dans l'ensemble des matériaux formés par l'aluminium, le cuivre, le titane, le platine, l'iridium, le zirconium, le rubidium, le molybdène, le nickel, le tungstène, l'or, le poly-silicium, les alliages de ces différents métaux, et
leur épaisseur est répartie de façon a obtenir une répartition de masse localisée en frontière de la plaque résonnante et du bloc de substrat de façon à piéger et concentrer les ondes de volume à l'intérieur d'une zone locale de la plaque résonnante.

9. Procédé de fabrication d'un résonateur piézoélectrique à ondes de volume fonctionnant à une fréquence prédéterminée comprenant les étapes suivantes :
- fournir une couche brute de substrat porteur, destinée à constituer un bloc de substrat du résonateur piézoélectrique, la couche brute de substrat porteur ayant une épaisseur de couche brute de substrat porteur et constituée en un matériau de substrat ;
- fournir (404) une couche brute de départ de plaque résonnante, destinée à constituer une plaque résonnante du résonateur piézoélectrique, la couche brute de départ de plaque résonnante étant constituée en un matériau piézoélectrique, ayant une épaisseur de couche brute eb, et une étendue spatiale dans un plan perpendiculaire à la direction de l'épaisseur nettement plus grande que l'épaisseur eb de la couche brute, l'orientation cristallographique de la couche brute ayant été préalablement choisie de sorte qu'il existe un plan de coupe cristallographique de la couche brute dans le sens de l'épaisseur eb pour lequel une tranche, découpée suivant le plan de coupe et ayant une épaisseur e2, réalise un résonateur piézoélectrique de type plan-plan à ondes de volume se propageant dans le sens de l'épaisseur de la tranche, avec un coefficient de couplage électro-acoustique supérieur ou égal à 0,0001 ;
- découper (406) par sciage dans le sens de l'épaisseur de la couche brute et partiellement ou totalement dans la couche brute de départ de plaque résonnante, une plaque résonnante ayant une épaisseur de plaque résonnante e2, une première et une deuxième faces planes disposées en vis-à-vis, les faces planes possédant une longueur L, une largeur l et, la découpe étant effectuée en même temps qu'un polissage des faces planes par un procédé d'usinage suivant la direction de plan de coupe, la largeur I de la plaque et l'épaisseur de la couche brute étant de même sens, le matériau et l'orientation cristallographique de la couche brute, la direction du plan de coupe, la longueur L, la largeur l, la deuxième épaisseur de la plaque résonnante étant configurés pour piéger des ondes de volume à la fréquence de fonctionnement du résonateur et pour réaliser un résonateur piézoélectrique à ondes de volume de type plan-plan, c'est-à-dire des ondes de volumes se propageant dans le sens de l'épaisseur de la plaque résonnante ;
- déposer (408) des première et deuxième électrodes métalliques recouvrant au moins en partie et respectivement la première face et la deuxième face de la plaque résonnante, et situées au moins partiellement en vis-à-vis,
**caractérisé en ce que** la rugosité des faces planes de la plaque résonante est de quelques dizaines à quelques nanomètres RMS, et **en ce que** le procédé de fabrication comprend l'étape consistant à
disposer, entre la couche brute de substrat porteur et la couche brute de départ de plaque résonnante, au moins une couche destinée à former un élément de fixation et/ou d'isolation acoustique à la fréquence de fonctionnement, distincte de la couche brute de substrat porteur et de la couche brute de départ de plaque résonnante, constituée en au moins un troisième matériau distinct du matériau de la couche brute de substrat porteur et distinct du matériau de la couche brute de départ de plaque résonnante, ladite au moins une couche destinée à former un élément de fixation et/ou d'isolation acoustique étant comprise dans l'ensemble constitué par une unique couche de colle et un miroir de Bragg formé d'un empilement de couches à impédances acoustiques contrastées,
découper au moins la couche brute de départ de plaque résonnante sur une certaine profondeur de façon à former la plaque résonnante.

10. Procédé de fabrication d'un résonateur piézoélectrique à ondes de volume selon la revendication 9, comprenant les étapes suivantes :
découper partiellement dans la couche brute de départ et dans le sens de l'épaisseur de la couche brute de départ la plaque résonnante, la découpe partielle dans le sens de l'épaisseur de la couche brute étant effectuée par enlèvement d'un premier barreau adjacent à la plaque au travers de la première face, et d'un deuxième barreau adjacent à la plaque au travers de la deuxième face,
de façon à obtenir la plaque résonnante et un bloc de substrat comme étant le reste de la couche brute après découpage des barreaux, porteur de la plaque et ayant une face plane de référence, la plaque étant fixée d'un seul tenant perpendiculairement à la face plane du bloc de substrat, la largeur l de la plaque étant ainsi une hauteur de la plaque par rapport au bloc de substrat.

## Patentansprüche

1. Piezoelektrischer Resonator für Raumwellen, der bei einer vorbestimmten Frequenz arbeitet und aufweist:
einen Substratblock (4; 64; 74), Träger, der eine ebene Fläche (16) hat, aufweisend eine erste Dicke e1 entlang einer Normalen der ebenen Fläche und gebildet aus einem ersten Material, und
eine Resonanzplatte (6; 36; 66; 76), welche eine erste und eine zweite ebene Fläche (8, 10) hat, die gegenüberliegend angeordnet sind, aufweisend eine Länge L, eine Breite l und eine zweite Dicke e2 und gebildet aus einem zweiten Material, wobei das besagte zweite Material piezoelektrisch ist,
eine erste und eine zweite Metallelektrode (12, 14; 42, 44; 54, 56), welche zumindest teilweise und jeweilig die erste Fläche (8) und die zweite Fläche (10) der Resonanzplatte (6; 36; 66; 76) bedecken und welche zumindest teilweise mittels der Resonanzplatte (6; 36; 66; 76) gegenüberliegend angeordnet sind,
wobei die Resonanzplatte (6; 36; 66; 76) senkrecht in der Nähe der ebenen Fläche (16) des Substratblocks (4; 64; 74) befestigt ist, sodass die Breite der Resonanzplatte (6; 36; 66; 76) und die erste Dicke des Substratblocks (4; 64; 74) eine gleiche Richtung haben, und
wobei das erste Material, das zweite Material, die erste Dicke des Substratblocks (4; 64; 74), die Länge, die Breite l, die zweite Dicke der Resonanzplatte (6; 36; 66; 76) eingerichtet sind, um Raumwellen mit der Arbeitsfrequenz des Resonators einzufangen und um einen piezoelektrischen Resonator für Raumwellen des eben-eben-Typs, das heißt Raumwellen, die sich in der Dickenrichtung der Resonanzplatte ausbreiten, zu realisieren,
**dadurch gekennzeichnet, dass** die Flächen der Resonanzplatte, die mittels Sägens zerschnitten ist, glatte Flächen sind, welche eine Rauigkeit von einigen zehn bis einigen Nanometern RMS aufweisen,
und dadurch, dass der piezoelektrische Resonator ein Element aufweist zur Befestigung und/oder zur akustischen Isolation (68; 78) bei der Arbeitsfrequenz f, welches verschieden ist von dem Substratblock (64; 74) und der Resonanzplatte (66; 76), welches gebildet ist aus mindestens einem dritten Material, welches verschieden ist von dem ersten und dem zweiten Material, wobei das Element zur Befestigung und/oder zur akustischen Isolation (67; 78) enthalten ist in einer Gruppe, die gebildet ist aus einer einzigen Klebstoff-Schicht und einem Bragg-Spiegel, der gebildet ist aus einem Stapel von Schichten mit unterschiedlichen akustischen Impedanzen.

2. Piezoelektrischer Resonator für Raumwellen gemäß Anspruch 1, wobei ein lateraler Formfaktor Fl, der definiert ist als das Verhältnis von der Breite l der Resonanzplatte (6; 36; 66; 76) zu der zweiten Dicke e2 der Resonanzplatte (6; 36; 66; 76), größer oder gleich 5, vorzugsweise größer oder gleich 10 ist.

3. Piezoelektrischer Resonator für Raumwellen gemäß irgendeinem der Ansprüche 1 bis 2, wobei ein longitudinaler Formfaktor, der definiert ist als das Verhältnis von der Länge der Resonanzplatte (6; 36; 66; 76) zu der Dicke der Resonanzplatte (6; 36; 66; 76), größer oder gleich 5, vorzugsweise größer oder gleich 10 ist.

4. Piezoelektrischer Resonator für Raumwellen gemäß irgendeinem der Ansprüche 1 bis 2, wobei die Resonanzplatte (6) und der Substratblock (4) aus einem gleichen piezoelektrischen Material gebildet sind und ein zusammenhängendes Teil bilden.

5. Piezoelektrischer Resonator gemäß irgendeinem der Ansprüche 1 bis 4, wobei
die Resonanzplatte (6; 76) und der Substratblock (4; 74) aus einem gleichen piezoelektrischen Material gebildet sind und
der kristallographische Schnitt der Resonanzplatte (6; 76) entlang einer Ebene, die parallel zu ihren zwei Flächen ist, so ausgewählt ist, dass der Koeffizient der elektroakustischen Kopplung des Transduktors, der mittels der Resonanzplatte gebildet ist, größer als 0,0001 ist für Raumwellen, die sich in der Dickenrichtung der Resonanzplatte ausbreiten.

6. Piezoelektrischer Resonator gemäß irgendeinem der Ansprüche 1 bis 5, **dadurch gekennzeichnet, dass** die Resonanzplatte (36) eine Drosselungszone (38) in der Dickenrichtung über ihre gesamte Länge hat, für welche die Dicke der Resonanzplatte (36) ein Minimum durchläuft, und die Resonanzplatte (36) an dem Substratblock (4) befestigt ist, wobei die Drosselungszone (38) in der Nähe der ebenen Fläche des Substratblocks (4) angeordnet ist.

7. Piezoelektrischer Resonator gemäß irgendeinem der Ansprüche 1 bis 6, wobei
das erste Material enthalten ist in der Gruppe von Materialien, die gebildet wird von Lithiumniobat, Lithiumtantalat, Kaliumniobat, piezoelektrischen Keramiken, Quarz, Lithiumtetraborat, Orthophosphat, Gallium, Langasit, Langatat, Langanit, Zinkoxid und Aluminiumnitrid,
das zweite Material enthalten ist in der Gruppe von Materialien, die gebildet wird von Lithiumniobat, Lithiumtantalat, Kaliumniobat, piezoelektrischen Keramiken, Quarz, Lithiumtetraborat, Orthophosphat, Gallium, Langasit, Langatat, Langanit, Diamantkohlenstoff, Silizium, Saphir.

8. Piezoelektrischer Resonator gemäß irgendeinem der Ansprüche 1 bis 7, wobei
die Metallelektroden (12, 14; 42, 44; 54, 56) aus einem Material hergestellt sind, welches enthalten ist in der Gruppe von Materialien, die gebildet sind aus Aluminium, Kupfer, Titan, Platin, Iridium, Zirkonium, Rubidium, Molybdän, Nickel, Wolfram, Gold, Polysilizium, Legierungen dieser verschiedenen Metalle, und
ihre Dicke verteilt ist, um eine Massenverteilung zu erhalten, die an der Grenze der Resonanzplatte und des Substratblocks lokalisiert ist, um die Raumwellen im Inneren einer lokalen Zone der Resonanzplatte einzufangen und zu konzentrieren.

9. Verfahren zum Herstellen eines piezoelektrischen Resonators für Raumwellen, der bei einer vorbestimmten Frequenz arbeitet, welches die folgenden Schritte aufweist:
- Bereitstellen einer Trägersubstrat-Rohschicht, die dazu bestimmt ist, einen Substratblock des piezoelektrischen Resonators zu bilden, wobei die Trägersubstrat-Rohschicht eine Trägersubstrat-Rohschicht-Dicke hat und aus einem Substrat-Material gebildet ist;
- Bereitstellen (404) einer Resonanzplatte-Ausgangs-Rohschicht, die dazu bestimmt ist, eine Resonanzplatte des piezoelektrischen Resonators zu bilden, wobei die Resonanzplatte-Ausgangs-Rohschicht aus einem piezoelektrischen Material gebildet ist, eine Rohschicht-Dicke eb und eine räumliche Ausdehnung in einer Ebene hat, die senkrecht zu der Dickenrichtung ist, die deutlich größer ist als die Dicke eb der Rohschicht, wobei die kristallographische Orientierung der Rohschicht zuvor so ausgewählt wurde, dass eine kristallographische Schnittebene der Rohschicht in der Dickenrichtung eb existiert, für welche eine Scheibe, die entlang der Schnittebene abgeschnitten ist und eine Dicke e2 hat, einen piezoelektrischen Resonator des eben-eben-Typs für Raumwellen realisiert, die sich in der Dickenrichtung der Scheibe ausbreiten, mit einem Koeffizienten der elektroakustischen Kopplung, der größer oder gleich 0,0001 ist;
- Schneiden (406) mittels Sägens in der Dickenrichtung der Rohschicht und teilweise oder vollständig in der Resonanzplatte-Ausgangs-Rohschicht von einer Resonanzplatte, die eine Resonanzplatte-Dicke e2 und eine erste und eine zweite ebene Fläche hat, die gegenüberliegend angeordnet sind, wobei die ebenen Flächen eine Länge L, eine Breite l haben und das Schneiden zur gleichen Zeit durchgeführt wird, wie ein Polieren der ebenen Flächen mittels eines Maschinenverfahrens entlang der Schnittebene-Richtung, wobei die Breite l der Platte und die Dicke der Rohschicht gleicher Richtung sind, das Material und die kristallographische Orientierung der Rohschicht, die Richtung der Schnittebene, die Länge L, die Breite l, die zweite Dicke der Resonanzplatte eingerichtet sind, um Raumwellen mit der Arbeitsfrequenz des Resonators einzufangen und um einen piezoelektrischen Resonator für Raumwellen des eben-eben-Typs, das heißt Raumwellen, die sich in der Dickenrichtung der Resonanzplatte ausbreiten, zu realisieren;
- Anordnen (408) von einer ersten und einer zweiten Metallelektrode, welche zumindest teilweise und jeweilig die erste Fläche und die zweite Fläche der Resonanzplatte bedecken und welche zumindest teilweise gegenüberliegend angeordnet sind,
**dadurch gekennzeichnet, dass** die Rauigkeit der ebenen Flächen der Resonanzplatte von einigen zehn bis einigen Nanometern RMS ist, und
dadurch, dass das Verfahren zum Herstellen den Schritt aufweist, der besteht aus
Anordnen zwischen der Trägersubstrat-Rohschicht und der Resonanzplatte-Ausgangs-Rohschicht von mindestens einer Schicht, die dazu bestimmt ist, ein Element zur Befestigung und/oder zur akustischen Isolation bei der Arbeitsfrequenz zu bilden, welche verschieden ist von der Trägersubstrat-Rohschicht und der Resonanzplatte-Ausgangs-Rohschicht der Resonanzplatte, welche gebildet ist aus mindestens einem dritten Material, welches verschieden ist von dem Material der Trägersubstrat-Rohschicht und welches verschieden ist von dem Material der Resonanzplatte-Ausgangs-Rohschicht, wobei die besagte mindestens eine Schicht, die dazu bestimmt ist, ein Element zur Befestigung und/oder zur akustischen Isolation zu bilden, enthalten ist in der Gruppe, die gebildet ist aus einer einzigen Klebstoff-Schicht und einem Bragg-Spiegel, der gebildet ist aus einem Stapel von Schichten mit unterschiedlichen akustischen Impedanzen,
Schneiden von mindestens der Resonanzplatte-Ausgangs-Rohschicht auf eine bestimmte Tiefe, um die Resonanzplatte zu bilden.

10. Verfahren zum Herstellen eines piezoelektrischen Resonators für Raumwellen gemäß Anspruch 9, welches die folgenden Schritte aufweist:
- teilweises Schneiden in der Ausgangs-Rohschicht und in der Dickenrichtung der Ausgangs-Rohschicht von der Resonanzplatte, wobei das Teil-Schneiden in der Dickenrichtung der Rohschicht durchgeführt wird mittels Entfernens eines ersten Stabes, der durch die erste Fläche benachbart ist zu der Platte, und eines zweitens Stabes, der durch die zweite Fläche benachbart ist zu der Platte,
um die Resonanzplatte und einen Substratblock als den Rest der Rohschicht nach dem Schneiden der Stäbe zu erhalten, welcher die Platte trägt und eine ebene Referenzebene hat, wobei die Platte in einem Stück senkrecht zu der ebenen Fläche des Substratblocks befestigt ist, wobei die Breite l der Platte daher eine Höhe der Platte bezüglich des Substratblocks ist.

## Claims

1. A bulk wave piezoelectric resonator operating at a predetermined frequency and comprising:
a block of substrate (4 ; 64 ; 74), as holding means, with a plane face (16), having a first thickness e1 along a normal to said plane face, and made of a first material, and
a resonant plate (6 ; 36 ; 66 ; 76), having first and second plane faces (8,10), which are positioned facing each other, the resonant plate having a length L, a width I and a second thickness e2, and being made of a second piezoelectric material, said second material being a piezoelectric material,
first and second metal electrodes (12, 14 ; 42, 44 ; 54 ,56), covering at least partly the first face (8) and the second face (10) of the resonant plate (6 ; 36 ; 66 ; 76), respectively, and located at least partly facing each other, through the resonant plate (6 ; 36 ; 66 ; 76),
the resonant plate (6 ; 36 ; 66 ; 76) being attached perpendicularly to the vicinity of the plane face (16) of the block of substrate (4 ; 64 ; 74) so that the width of the resonant plate (6 ; 36 ; 66 ; 76) and the first thickness of the block of substrate (4 ; 64 ; 74) have a same direction, and
the first material, the second material, the first thickness of the block of substrate (4 ; 64 ; 74), the length L, the width I, the second thickness e2 of the resonant plate (6 ; 36 ; 66 ; 76) being configured for trapping bulk waves at the operating frequency of the resonator and for producing a bulk wave piezoelectric resonator of the plane-plane type, i.e. bulk waves propagating in the direction of the thickness of the resonant plate,
**characterised in that** the surfaces of the resonant plate cut by sawing are polished surfaces having a roughness of a few tens to a few RMS nanometers,
and **in that** the piezoelectric resonator comprises an attachment element and/or an acoustic insulation element (68 ;78) at the operating frequency f, distinct from the block of substrate (64 ;74) and the resonant plate (66 ; 76), made of at least one third material distinct from the first and second materials, the attachment element and/or acoustic insulation element (68 ; 78) being comprised in a group made of a single adhesive layer and a Bragg mirror formed by a stack of layers with contrasted acoustic impedances.

2. The bulk wave piezoelectric resonator according to claim 1, wherein a lateral form factor Fl, defined as the ratio of the width l of the resonant plate (6 ; 36 ; 66 ; 76) over the second thickness e2 of the resonant plate (6 ; 36 ; 66 ; 76), is greater than or equal to 5, preferably greater than or equal to 10.

3. The bulk wave piezoelectric resonator according to any of claims 1 to 2, wherein a longitudinal form factor, defined as the ratio of the length of the resonant plate (6 ; 36 ; 66 ; 76) over the thickness of the resonant plate (6 ; 36 ; 66 ; 76), is greater than or equal to 5, preferably greater than or equal to 10.

4. The bulk wave piezoelectric resonator according to any of claims 1 to 2, wherein the resonant plate (6) and the block of substrate (4) are made in a same piezoelectric material and forms a part in one piece.

5. The piezoelectric resonator according to any of claims 1 to 4, wherein
the resonant plate (6 ; 76) and the block of substrate (4 ; 74) consist in a same piezoelectric material, and
the crystallographic cut of the resonant plate (6 ; 76) along a plane parallel to both of its faces is selected so that the electro-acoustic coupling coefficient of the transducer formed by the resonant plate is greater than 0.0001 for bulk waves propagating in the direction of the thickness of the resonant plate.

6. The piezoelectric resonator according to any of claims 1 to 5, **characterized in that** the resonant plate (36) has a constriction area (38) in the direction of the thickness over the whole of its length for which the thickness of the resonant plate (36) passes through a minimum, and the resonant plate (36) being attached to the block of substrate (4), the constriction area (38) is located in the vicinity of the plane face of the block of substrate (4).

7. The piezoelectric resonator according to any of claims 1 to 6, wherein
the first material is comprised in the set of materials formed with lithium niobate, lithium tantalate, potassium niobate, piezoelectric ceramics, quartz, lithium tetraborate, gallium orthophosphate, langasite, langatate, langanite, zinc oxide and aluminum nitride,
and the second material is comprised in the set of materials formed with lithium niobate, lithium tantalate, potassium niobate, piezoelectric ceramics, quartz, lithium tetraborate, gallium orthophosphate, langasite, langatate, langanite, diamond carbon, silicon, sapphire.

8. The piezoelectric resonator according to any of claims 1 to 7, wherein
the metal electrodes (12, 14 ; 42, 44 ; 54, 56) are made in a material comprised in the set of materials formed with aluminum, copper, titanium, platinum, iridium, zirconium, rubidium, molybdenum, nickel, tungsten, gold, poly-silicon, alloys of these various metals, and
their thickness is distributed so as to obtain a mass distribution localized at the boundary of the resonant plate and of the block of substrate so as to trap and concentrate the bulk waves inside a local area of the resonant plate.

9. A method for manufacturing a bulk wave piezoelectric resonator operating at a predetermined frequency comprising the following steps:
- providing a holding substrate crude layer, intended to form a block of substrate of the piezoelectric resonator, the holding substrate crude layer having a holding substrate crude layer thickness and being made of a substrate material;
- providing (404) an initial resonant plate crude layer, intended to form a resonant plate of the piezoelectric resonator, the initial resonant plate crude layer consisting in a piezoelectric material with a crude layer thickness eb and a spatial extent in a plane perpendicular to the direction of the thickness larger than the thickness eb of the crude layer, the crystallographic orientation of the crude layer having been selected beforehand so that there exists a crystallographic cut plane of the crude layer in the direction of the thickness eb, for which a wafer cut out along the cut plane and having a thickness e2, produces a piezoelectric resonator of the plane-plane type with bulk waves propagating in the direction of the thickness of the wafer, with an electro-acoustic coupling coefficient greater than or equal to 0.0001;
- cutting out (406) by sawing in the direction of the thickness of the crude layer and partly or totally in the initial resonant plate crude layer, a resonant plate having a resonant plate thickness e2, first and second plane faces positioned facing each other, the plane faces having a length L, a width l and, the cutting out being carried out at the same time than the polishing of the flat surfaces with a machining method along the direction of the cut plane, the width I of the plates and the thickness of the crude layer being along the same direction, the material and the crystallographic orientation of the crude layer, the direction of the cut plane, the length L, the width l, the second thickness of the resonant plate being configured for trapping bulk waves at the operating frequency of the resonator and for producing a bulk wave piezoelectric resonator of the plane-plane type, i.e. bulk waves propagating in the direction of the thickness of the resonant plate;
- depositing (408) first and second metal electrodes covering at least partly the first face and the second face of the resonant plate respectively, and located at least partly facing each other,
**characterised in that** the roughness of the plane surfaces of the resonant plate is a few tens to a few RMS nanometers, and **in that** the method of manufacturing comprises the steps consisting in :
positioning between the holding substrate crude layer and the initial resonant plate crude layer at least one layer intended to form an attachment element and/or an acoustic insulation element at the operating frequency, distinct from the holding substrate crude layer and the initial resonant plate crude layer, made of at least one third material distinct from the material of the holding substrate crude layer and the material of the initial resonant plate crude layer, said at least one layer forming the attachment element and/or the acoustic insulation element being comprised in a group formed by a single adhesive layer and a Bragg mirror formed with a stack of layers with contrasting acoustic impedances,
cutting out the initial resonant plate crude layer over a certain depth so as to form the resonant plate.

10. A method for manufacturing a bulk wave piezoelectric resonator according to claim 9, comprising the following steps:
partly cutting out in the initial crude layer and in the direction of the thickness of the initial crude layer, the resonant plate, the partial cutting out in the direction of the thickness of the crude layer being carried out by removing a first bar adjacent to the plate through the first face, and a second bar adjacent to the plate through the second face,
so as to obtain the resonant plate and a block of substrate as the remainder of the crude layer after cutting the bars, bearing the plate and having a reference plane face, the plate being attached in one piece perpendicularly to the plane face of the block of substrate, the width I of the plate thereby being a height of the plate relatively to the block of substrate.
